# EUROPÄISCHE PATENTSCHRIFT

(11) **EP 4 213 174 B1**
(45) Veröffentlichungstag und Bekanntmachung des Hinweises auf die Patenterteilung: **16.10.2024**
(21) Anmeldenummer: 22207382.7
(22) Anmeldetag: 15.11.2022
(51) Int. Cl.: H01H 71/02

(54) **EINPOLIGES GEHÄUSEMODUL UND NIEDERSPANNUNGS-SCHUTZSCHALTGERÄT**
SINGLE POLE HOUSING MODULE AND LOW VOLTAGE CIRCUIT BREAKER
MODULE DE BOÎTIER UNIPOLAIRE ET DISJONCTEUR BASSE TENSION

(30) Priorität: 13.01.2022 DE 102022200296
(43) Veröffentlichungstag der Anmeldung: 19.07.2023
(73) Patentinhaber: Siemens Aktiengesellschaft, 80333 München (DE)
(72) Erfinder: Mundt, Andreas, 93102 Pfatter (DE); Malich, Timo, 92245 Kümmersbruck (DE); Nörl, Gerald, 93133 Burglengenfeld (DE)
(74) Vertreter: Siemens Patent Attorneys

(56) Entgegenhaltungen:
- EP-A2- 3 035 359
- AT-A1- 501 217
- DE-A1- 102018 202 204

## Beschreibung

Einpoliges Gehäusemodul und Niederspannungs-Schutzschaltgerät Die Erfindung betrifft ein einpoliges Gehäusemodul aus Isolierstoff für ein aus mehreren Modulen aufgebautes, mehrpoliges Niederspannungs-Schutzschaltgerät gemäß dem Oberbegriff des unabhängigen Anspruchs 1, derartige Gehäusemodule sind aus DE 10 2018 202204 A1 bekannt. Weiterhin betrifft die Erfindung ein Niederspannungs-Schutzschaltgerät, welches zumindest zwei derartige, nebeneinander angeordnete Gehäusemodule aufweist. Elektromechanische Schutzschaltgeräte - beispielsweise Leistungsschalter, Leitungsschutzschalter, Fehlerstromschutzschalter sowie Lichtbogen- bzw. Brandschutzschalter - dienen der Überwachung sowie der Absicherung eines elektrischen Stromkreises und werden insbesondere als Schalt- und Sicherheitselemente in elektrischen Energieversorgungs- und Verteilnetzen eingesetzt. Zur Überwachung und Absicherung des elektrischen Stromkreises wird das Schutzschaltgerät über zwei oder mehrere Anschlussklemmen mit einer elektrischen Leitung des zu überwachenden Stromkreises elektrisch leitend verbunden, um bei Bedarf den elektrischen Strom in der jeweiligen überwachten Leitung zu unterbrechen. Das Schutzschaltgerät weist hierzu zumindest einen Schaltkontakt auf, der bei Auftreten eines vordefinierten Zustandes - beispielsweise bei Erfassen eines Kurzschlusses oder eines Fehlerstromes - geöffnet werden kann, um den überwachten Stromkreis vom elektrischen Leitungsnetz zu trennen. Derartige Schutzschaltgeräte sind auf dem Gebiet der Niederspannungstechnik auch als Reiheneinbaugeräte bekannt.

Leistungsschalter sind dabei speziell für hohe Ströme ausgelegt. Ein Leitungsschutzschalter (sogenannter LS-Schalter), welcher auch als "Miniature Circuit Breaker" (MCB) bezeichnet wird, stellt in der Elektroinstallation eine sogenannte Überstromschutzeinrichtung dar und wird insbesondere im Bereich der Niederspannungsnetze eingesetzt. Leistungsschalter und Leitungsschutzschalter garantieren ein sicheres Abschalten bei Kurzschluss und schützen Verbraucher und Anlagen vor Überlast, beispielsweise vor Beschädigung der elektrischen Leitungen durch zu starke Erwärmung in Folge eines zu hohen elektrischen Stromes. Sie sind dazu ausgebildet, einen zu überwachenden Stromkreis im Falle eines Kurzschlusses oder bei Auftreten einer Überlast selbsttätig abzuschalten und damit vom übrigen Leitungsnetz zu trennen. Leistungsschalter und Leitungsschutzschalter werden daher insbesondere als Schalt- und Sicherheitselemente zur Überwachung und Absicherung eines elektrischen Stromkreises in elektrischen Energieversorgungsnetzen eingesetzt. Leitungsschutzschalter sind aus den Druckschriften DE 10 2015 217 704 A1, EP 2 980 822 A1, DE 10 2015 213 375 A1, DE 10 2013 211 539 A1 oder auch EP 2 685 482 B1 prinzipiell vorbekannt.

Zur Unterbrechung einer einzigen Phasenleitung wird in der Regel ein einpoliger Leitungsschutzschalter verwendet, welche üblicher Weise eine Breite von einer Teilungseinheit (entspricht ca. 18mm) aufweist. Für dreiphasige Anschlüsse werden (alternativ zu drei einpoligen Schaltgeräten) dreipolige Leitungsschutzschalter eingesetzt, welche dementsprechend eine Breite von drei Teilungseinheiten (entspricht ca. 54mm) aufweisen. Jedem der drei Phasenleiter ist dabei ein Pol, d.h. eine Schaltstelle zugeordnet. Soll zusätzlich zu den drei Phasenleitern auch noch der Neutralleiter unterbrochen werden, spricht man von vierpoligen Geräten, welche vier Schaltstellen aufweisen: drei für die drei Phasenleiter sowie einen für den gemeinsamen Neutralleiter.

Daneben existieren kompakte Leitungsschutzschalter, welche bei einer Gehäusebreite von nur einer Teilungseinheit zwei Schaltkontakte für je eine Anschlussleitung, d.h. entweder für zwei Phasenleitungen (Kompaktleitungsschutzschalter vom Typ 1+1) oder für eine Phasenleitung und den Neutralleiter (Kompaktleitungsschutzschalter vom Typ 1+N), bereitstellen. Derartige Kompakt-Schutzschaltgeräte in Schmalbauweise sind beispielsweise aus den Druckschriften DE 10 2004 034 859 A1, EP 1 191 562 B1 oder EP 1 473 750 A1 prinzipiell vorbekannt.

Ein Fehlerstromschutzschalter ist eine Schutzeinrichtung zur Gewährleistung eines Schutzes gegen einen gefährlichen Fehlerstrom in einer elektrischen Anlage. Ein derartiger Fehlerstrom - welcher auch als Differenzstrom bezeichnet wird - tritt auf, wenn ein spannungsführendes Leitungsteil einen elektrischen Kontakt gegen Erde aufweist. Dies ist beispielsweise dann der Fall, wenn eine Person ein spannungsführendes Teil einer elektrischen Anlage berührt: in diesem Fall fließt der Strom als Fehlerstrom durch den Körper der betreffenden Person gegen die Erdung ab. Zum Schutz gegen derartige Körperströme muss der Fehlerstromschutzschalter bei Auftreten eines derartigen Fehlerstroms die elektrische Anlage schnell und sicher allpolig vom Leitungsnetz trennen. Im Allgemeinen Sprachgebrauch werden anstelle des Begriffs "Fehlerstromschutzschalter" auch die Begriffe FI-Schutzschalter (kurz: FI-Schalter), Differenzstromschutzschalter (kurz: DI-Schalter) oder RCD (für "Residual Current Protective Device") gleichwertig verwendet.

Zur Erfassung eines derartigen Fehler- bzw. Differenzstromes wird die Größe des Stromes in einer zu einem elektrischen Verbraucher hinführenden Leitung, beispielsweise einer Phasenleitung, mit der Größe des Stromes in einer vom elektrischen Verbraucher zurückführenden Leitung, beispielsweise eines Neutralleiters, mit Hilfe eines sogenannten Summenstromwandlers verglichen. Dieser weist einen ringförmigen Magnetkern auf, durch den die Primärleiter (hin- und rückführende elektrische Leitungen) hindurchgeführt sind. Der Magnetkern selbst ist mit einem Sekundärleiter bzw. einer Sekundärwicklung umwickelt. Im fehlerstromfreien Zustand ist die Summe der zu dem Verbraucher hinfließenden elektrischen Ströme gleich der Summe der vom Verbraucher zurückfließenden elektrischen Ströme. Werden die Ströme vektoriell, d.h. richtungsbezogen bzw. vorzeichenbehaftet, addiert, so folgt hieraus, dass die vorzeichenbehaftete Summe der elektrischen Ströme in den Hin- und Rückleitungen im fehlerstromfreien Zustand gleich Null ist: im Sekundärleiter wird kein Induktionsstrom induziert. Im Unterschied dazu ist im Falle eines Fehler- bzw. Differenzstromes, der gegen Erde abfließt, die im Summenstromwandler erfasste Summe der hin- beziehungsweise zurückfließenden elektrischen Ströme ungleich Null. Die dabei auftretende Stromdifferenz führt dazu, dass an der Sekundärwicklung eine der Stromdifferenz proportionale Spannung induziert wird, wodurch ein Sekundärstrom in der Sekundärwicklung fließt. Dieser Sekundärstrom dient als Fehlerstromsignal und führt nach Überschreiten eines vorbestimmten Wertes zum Auslösen des Schutzschaltgerätes und infolgedessen - durch Öffnen des zumindest einen Schaltkontaktes des Schutzschaltgerätes - zur Abschaltung des entsprechend abgesicherten Stromkreises.

Bei Fehlerstromschutzschaltern wird ferner zwischen netzspannungsabhängigen und netzspannungsunabhängigen Gerätetypen unterschieden: während netzspannungsabhängige Fehlerstromschutzschalter eine Steuerungselektronik mit einem Auslöser aufweisen, die zur Erfüllung ihrer Funktion auf eine Hilfs- oder Netzspannung angewiesen ist, benötigen netzspannungsunabhängige Fehlerstromschutzschalter zur Realisierung der Auslösefunktion keine Hilfs- oder Netzspannung, sondern weisen zur Realisierung der netzspannungsunabhängigen Auslösung in der Regel einen etwas größeren Summenstromwandler auf, wodurch ein größerer Induktionsstrom in der Sekundärwicklung erzeugt werden kann.

Lichtbogen- bzw. Brandschutzschalter werden zur Erfassung von Störlichtbögen, wie sie an einer defekten Stelle einer elektrischen Leitung - beispielsweise einer lockeren Kabelklemme oder aufgrund eines Kabelbruchs - auftreten können, verwendet. Tritt der Störlichtbogen elektrisch in Reihe zu einem elektrischen Verbraucher auf, so wird der normale Betriebsstrom im Regelfall nicht überschritten, da er durch den Verbraucher begrenzt wird. Aus diesem Grund wird der Störlichtbogen von einer herkömmlichen Überstromschutzeinrichtung, beispielsweise einer Schmelzsicherung oder eines Leitungsschutzschalters, nicht erfasst. Zur Ermittlung, ob ein Störlichtbogen vorliegt, werden durch den Brandschutzschalter sowohl der Spannungsverlauf als auch der Stromverlauf über die Zeit gemessen und hinsichtlich der für einen Störlichtbogen charakteristischen Verläufe analysiert und ausgewertet. In der (englischsprachigen) Fachliteratur werden derartige Schutzeinrichtungen zur Erfassung von Störlichtbögen als "Arc Fault Detection Device" (abgekürzt: AFDD) bezeichnet. Im nordamerikanischen Raum ist die Bezeichnung "Arc Fault Circuit Interrupter" (abgekürzt: AFCI) geläufig.

Daneben existieren auch Gerätebauformen, bei denen die Funktionalität eines Fehlerstrom-Schutzschalters mit der Funktionalität eines Leitungsschutzschalters kombiniert wird: derartige kombinierte Schutzschaltgeräte werden im Deutschen als FI/LS oder im englischsprachigen Raum als RCBO (für Residual current operated Circuit-Breaker with Overcurrent protection) bezeichnet. Diese Kombigeräte haben im Vergleich zu getrennten Fehlerstrom- und Leitungsschutzschaltern den Vorteil, dass jeder Stromkreis seinen eigenen Fehlerstrom-Schutzschalter aufweist: Normalerweise wird ein einziger FehlerstromSchutzschalter für mehrere Stromkreise verwendet. Kommt es zu einem Fehlerstrom, werden somit in Folge alle abgesicherten Stromkreise abgeschaltet. Durch den Einsatz von RCBOs wird nur der jeweils betroffene Stromkreis abgeschaltet.

Tendenziell werden immer mehr Funktionalitäten in die Geräte integriert, d.h. es werden kombinierte Schutzschaltgeräte entwickelt, welche den Funktionsumfang mehrerer Einzelgeräte abdecken: neben den vorstehend bereits beschriebenen FI/LS-Schutz-schalt-geräten, welche den Funktionsumfang eines herkömmlichen Fehlerstromschutzschalters (FI) mit dem eines Leitungsschutzschalters (LS) kombinieren, existieren weitere Bauformen, bei denen beispielsweise die Funktionalität eines Brandschutzschalters in bestehende Geräte wie MCB, RCD oder RCBO/FILS integriert werden.

Insbesondere bei mehrpoligen Fehlerstromschutzschaltern - ob als reiner Fehlerstromschutzschalter oder als kombinierte Gärätebauform wie FI/LS bzw. RCBO - sowie bei kombinierten Schutzschaltgeräten werden elektronische Funktionsbaugruppen verwendet, welche zur Realisierung einer oder mehrerer Funktionen des jeweiligen Schutzschaltgerätes benötigt werden. Derartige elektronische Funktionsbaugruppen müssen einerseits in dem dicht gepackten Gehäuse des jeweiligen Schutzschaltgerätes angeordnet, d.h. aufgenommen und gehaltert, sein, als auch mit elektrischer Energie versorgt werden.

Es ist deshalb die Aufgabe der vorliegenden Erfindung, ein alternatives Gehäuse sowie ein Niederspannungs-Schutzschaltgerät mit einem derartigen Gehäuse bereitzustellen, welches sich durch eine einfache Montage bei gleichzeitig geringen Herstellkosten auszeichnet.

Diese Aufgabe wird erfindungsgemäß durch das Gehäusemodul sowie das Niederspannungs-Schutzschaltgerät gemäß den unabhängigen Ansprüchen gelöst. Vorteilhafte Ausgestaltungen des erfindungsgemäßen Gehäusemoduls sowie des erfindungsgemäßen Niederspannungs-Schutzschaltgerätes sind Gegenstand der abhängigen Ansprüche.

Das erfindungsgemäße einpolige Gehäusemodul aus Isolierstoff für ein aus mehreren Gehäusemodulen aufgebautes, mehrpoliges Niederspannungs-Schutzschaltgerät weist eine Frontseite, eine der Frontseite gegenüberliegend angeordnete Befestigungsseite, sowie die Front- und die Befestigungsseite verbindende, erste und zweite Schmal- und Breitseiten auf. Weiterhin weist das Gehäusemodul einen von der Befestigungsseite aus zugänglichen modularen Aufnahmeraum auf, welcher bei einer Kombination des Gehäusemoduls mit einem weiteren Gehäusemodul einen modulübergreifenden Aufnahmeraum bildet, der zur Aufnahme einer modulübergreifenden Elektronikbaugruppe vorgesehen und ausgebildet ist.

Unter dem Begriff "einpolig" ist zu verstehen, dass das Gehäusemodul die Breite eines sogenannten "einpoligen Reiheneinbaugerätes" aufweist, dessen Breite einer Teilungseinheit von ca. 18mm entspricht. Bei Kombination des Gehäusemoduls mit einem weiteren Gehäusemodul, d.h. bei einer Aneinanderreihung Breitseite an Breitseite, bilden die beiden Aufnahmeräume der beiden Gehäusemodule einen modulübergreifend nutzbaren Aufnahmeraum, welcher in einem Randbereich der Befestigungsseite angeordnet und zur Aufnahme einer größeren modulübergreifenden Elektronikbaugruppe des mehrpoliges Niederspannungs-Schutzschaltgerätes, vorgesehen und ausgebildet ist. In dem modulübergreifend nutzbaren Aufnahmeraum, welcher einen Zugang zu allen Gehäusemodulen des mehrpoliges Niederspannungs-Schutzschaltgerätes ermöglicht, ist beispielsweise eine modulübergreifende Spannungsversorgung für in den einzelnen Gehäusemodulen anordenbare elektronischen Funktionsbaugruppen realisierbar. Angesichts der zunehmenden Integration zusätzlicher Funktionen in die Schutzschaltgeräte kann dadurch das Packaging, d.h. die Anordnung der einzelnen Komponenten in den Gehäusemodulen, deutlich vereinfacht werden.

In einer vorteilhaften Weiterbildung des Gehäusemoduls ist der modulare Aufnahmeraum nach außen, d.h. zur Umgebung hin, verschließbar, beispielsweise mit Hilfe eines geeigneten Verschlusselements wie eines Deckels. Das Verschlusselement kann dabei geschraubt oder schraubenlos fixierbar sein, beispielsweise mittels einer oder mehrere Schnappverbindungen. Mit Hilfe des Verschlusselements ist ein Schutz der dahinter angeordneten modulübergreifenden Elektronikbaugruppe vor Verschmutzung wie Staub oder Freuchtigkeit, aber auch vor unbeabsichtigter Berührung, realisierbar.

In einer weiteren vorteilhaften Weiterbildung weist das Gehäusemodul einen ersten Klemmen-Aufnahmeraum zur Aufnahme einer ersten Anschlussklemme, welcher im Bereich der ersten Schmalseite in dem Gehäusemodul ausgebildet ist, sowie einen zweiten Klemmen-Aufnahmeraum zur Aufnahme einer zweiten Anschlussklemme, welcher im Bereich der zweiten Schmalseite in dem Gehäusemodul ausgebildet ist, auf, wobei der modulübergreifende Aufnahmeraum unterhalb des zweiten Klemmen-Aufnahmeraums angeordnet ist.

Über die in dem ersten sowie dem zweiten Klemmen-Aufnahmeraum anordenbare erste und zweite Anschlussklemme, welche auch als Eingangsklemme und Ausgangsklemme bezeichnet werden können, ist das Niederspannungs-Schutzschaltgerät mit einem zu überwachenden elektrischen Stromkreis elektrisch leitend verbindbar. Der modulübergreifende Aufnahmeraum ist dabei unterhalb des zweiten Klemmen-Aufnahmeraums angeordnet, um eine einfache Kontaktierung der modulübergreifenden Elektronikbaugruppe mit der darüber anordenbaren Anschlussklemme zu ermöglichen, wodurch auf einfache Art und Weise eine Spannungsversorgung der modulübergreifenden Elektronikbaugruppe sowie der mit dieser verbundenen zumindest einen elektronische Funktionsbaugruppe realisierbar ist.

In einer weiteren vorteilhaften Weiterbildung weist das Gehäusemodul einen ersten Funktionsbereich und einem zweiten Funktionsbereich auf, welche nebeneinander angeordnet sind. Der erste Funktionsbereich dient dabei als Strompfadbereich, welcher dazu vorgesehen und ausgebildet ist, einen mittels eines Schaltkontakts unterbrechbaren Strompfad sowie ein magnetisches und ein thermisches Auslösesystem zum Öffnen des Schaltkontakts aufzunehmen, während der zweite Funktionsbereich dazu vorgesehen und ausgebildet ist, eine elektronische Funktionsbaugruppe aufzunehmen.

Der erste Funktionsbereich und der zweite Funktionsbereich sind somit zum einen zwischen dem ersten Klemmen-Aufnahmeraum und dem zweiten Klemmen-Aufnahmeraum, und zum anderen - bei einer Breite von nur einer Teilungseinheit - in einer Orthogonalenrichtung der Breitseiten gesehen nebeneinander angeordnet, wobei sich zwischen den beiden Klemmen-Aufnahmeräumen jeder der beiden Funktionsbereiche von der ersten Schmalseite zur gegenüberliegenden zweiten Schmalseite erstreckt. Auf diese Weise ist eine hohe Packungsdichte bei der Aufteilung und Anordnung der einzelnen Komponenten des mehrpoligen Niederspannungs-Schutzschaltgerätes in den das Schutzschaltgerät bildenden Gehäusemodulen realisierbar.

In einer weiteren vorteilhaften Weiterbildung des Gehäusemoduls weisen der erste Funktionsbereich und der zweite Funktionsbereich jeweils einen schmalen Teilbereich sowie einen breiten Teilbereich auf, wobei der schmale Teilbereich des ersten Funktionsbereichs neben dem breiten Teilbereich des zweiten Funktionsbereichs und der breite Teilbereich des ersten Funktionsbereichs neben dem schmalen Teilbereich des zweiten Funktionsbereichs angeordnet sind.

Hieraus ergibt sich der Vorteil, dass in dem breiten Teilbereich eines jeden Funktionsbereichs eine entsprechend voluminöse Baugruppe, beispielsweise das magnetische Auslösesystem, anordenbar ist, während in dem schmalen Teilbereich entsprechend eine weniger voluminöse Baugruppe, beispielsweise das thermische Auslösesystem, anordenbar ist. Auf diese Weise kann der in den Niederspannungs-Schutzschaltgeräten stark begrenzte Bauraum besser ausgenutzt werden.

In einer weiteren vorteilhaften Weiterbildung des Gehäusemoduls ist die elektronische Funktionsbaugruppe im schmalen Teilbereich des zweiten Funktionsbereichs anordenbar.

Da es sich bei der elektronischen Funktionsbaugruppe zumeist um eine bestückte Leiterplatte handelt, welche sich durch eine eher geringe Bauhöhe auszeichnet, ist diese in dem schmalen Teilbereich des zweiten Funktionsbereichs anordenbar.

In einer weiteren vorteilhaften Weiterbildung weist das Gehäusemodul eine Einschuböffnung auf, welche sich von der einen zur anderen Breitseite erstreckt, wodurch ein Einbauraum gebildet ist, welcher bei einer Kombination mit einem weiteren Gehäusemodul als modulübergreifender Einbauraum zur Aufnahme eines Summenstromwandlers vorgesehen ist.

Der Summenstromwandler eines mehrpoligen Fehlerstromschutzschalters stellt aufgrund des Magnetkerns, durch den alle Strompfade, d.h. zumindest ein Phasenleiter sowie der Neutralleiter, hindurchgeführt werden müssen, ein großvolumiges Bauteil dar, welches darüber hinaus schwierig zu montieren ist. Werden zwei oder mehrere Gehäusemodule Breitseite an Breitseite nebeneinander angeordnet, so wird durch die nebeneinander liegenden Einschuböffnungen ein modulübergreifender Einschubraum gebildet, in den der Summenstromwandler seitlich eingeschoben werden kann. Die Montage des Summenstromwandler wird dadurch deutlich vereinfacht.

In einer weiteren vorteilhaften Weiterbildung des Gehäusemoduls ist die Einschuböffnung im Bereich des schmalen Teilbereichs des ersten Funktionsbereichs sowie des daneben angeordneten breiten Teilbereichs des zweiten Funktionsbereichs von der einen zur anderen Breitseite verlaufend ausgebildet. Da die breiten Teilbereiche der zweiten Funktionsbereiche sowie die schmalen Teilbereiche der ersten Funktionsbereiche nicht durch andere Komponenten des Niederspannungs-Schutzschaltgerätes genutzt werden, ist dieses Bauvolumen ideal für den modulübergreifenden Einschubraum nutzbar.

Das erfindungsgemäße Niederspannungs-Schutzschaltgerät weist zumindest zwei nebeneinander angeordnete Gehäusemodule der vorstehend beschriebenen Art auf, wobei in einem ersten Funktionsbereich zumindest eines der Gehäusemodule ein Strompfad, ein Schaltkontakt sowie ein magnetisches und ein thermisches Auslösesystem zum Öffnen des Schaltkontakts aufgenommen und gehaltert sind, um den Strompfad bei Auftreten eines vordefinierten Ereignisses zu unterbrechen, während in einem zweiten Funktionsbereich zumindest eines der Gehäusemodule eine elektronische Funktionsbaugruppe aufgenommen und gehaltert ist. Dabei ist durch die nebeneinander angeordneten Aufnahmeräume der zumindest zwei Gehäusemodule ein modulübergreifender Aufnahmeraum gebildet, in dem eine modulübergreifenden Elektronikbaugruppe aufgenommen und gehaltert ist, welche mit der zumindest einen elektronischen Funktionsbaugruppe elektrisch leitend verbunden ist.

Durch die Kombination der zumindest zwei nebeneinander, d.h. Breitseite an Breitseite, angeordneten, vorstehend beschriebenen Gehäusemodule wird durch die Verbindung der beiden Aufnahmeräume ein modulübergreifender Aufnahmeraum gebildet, welcher zur Aufnahme einer größeren, modulübergreifenden Elektronikbaugruppe ausgebildet, d.h. geeignet ist. in jedem der zweiten Funktionsbereiche der Gehäusemodule ist eine elektronische Funktionsbaugruppe anordenbar, welche mit der modulübergreifenden Elektronikbaugruppe elektrisch leitend verbunden ist. Auf diese Weise ist eine Stromversorgung der elektronischen Funktionsbaugruppe bzw. eine gemeinsame Stromversorgung der mehreren elektronischen Funktionsbaugruppen realisierbar. Hinsichtlich der weiteren Vorteile des erfindungsgemäßen Niederspannungs-Schutzschaltgerätes wird auf die vorstehenden Ausführungen das erfindungsgemäße Gehäusemodul betreffend verwiesen.

In einer vorteilhaften Weiterbildung des Niederspannungs-Schutzschaltgerätes sind im ersten Klemmen-Aufnahmeraum jedes der Gehäusemodule jeweils eine erste Anschlussklemme und im zweiten Klemmen-Aufnahmeraum jedes der Gehäusemodule jeweils eine zweite Anschlussklemme aufgenommen und gehaltert, wobei die modulübergreifende Elektronikbaugruppe mit zumindest einer der Anschlussklemmen elektrisch leitend verbunden ist. Hierdurch kann die modulübergreifende Elektronikbaugruppe auf einfache Art und Weise mit elektrischer Spannung versorgt werden.

Im Folgenden zwei Ausführungsbeispiele des Gehäusemoduls bzw. Des Niederspannungs-Schutzschaltgerätes unter Bezug auf die beigefügten Figuren näher erläutert. In den Figuren sind:

### Figuren

- 1 und 2: schematische Schnittdarstellungen eines ersten Ausführungsbeispiels des erfindungsgemäßen Gehäusemoduls in verschiedenen Ansichten;
- Figur 3: eine schematische Schnittdarstellung eines ersten Ausführungsbeispiels des erfindungsgemäßen Niederspannungs-Schutzschaltgerätes in einer Draufsicht;
- Figur 4: eine schematische Darstellung der Befestigungsseite des ersten Ausführungsbeispiels des erfindungsgemäßen Niederspannungs-Schutzschaltgerätes;
- Figur 5: schematische Darstellung eines zweiten Ausführungsbeispiels des erfindungsgemäßen Gehäusemoduls;
- Figur 6: schematische Darstellung eines zweiten Ausführungsbeispiels des erfindungsgemäßen NiederspannungsSchutzschaltgerätes.

In den verschiedenen Figuren der Zeichnung sind gleiche Teile stets mit dem gleichen Bezugszeichen versehen. Die Beschreibung gilt für alle Zeichnungsfiguren, in denen das entsprechende Teil ebenfalls zu erkennen ist.

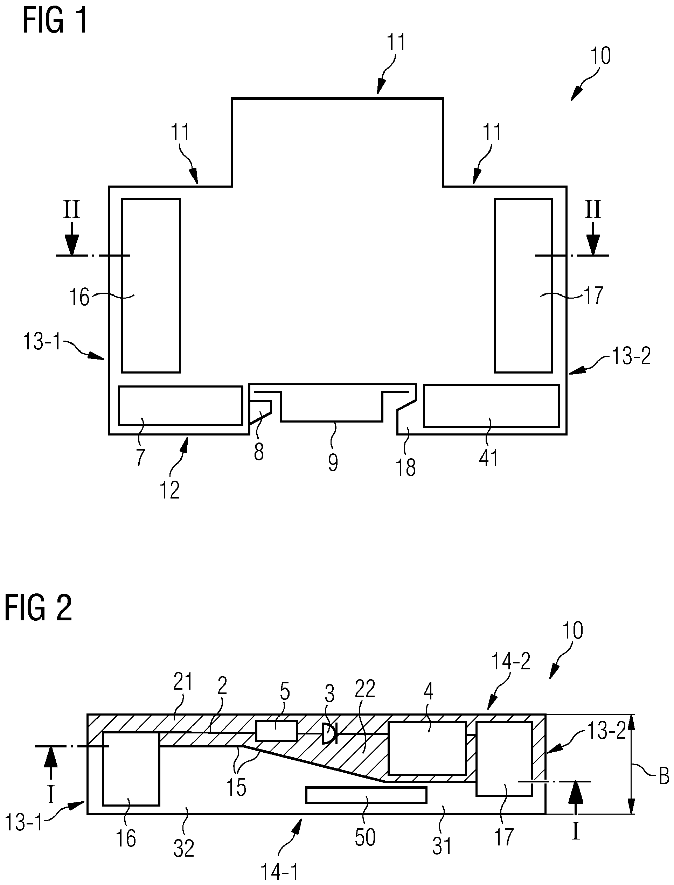

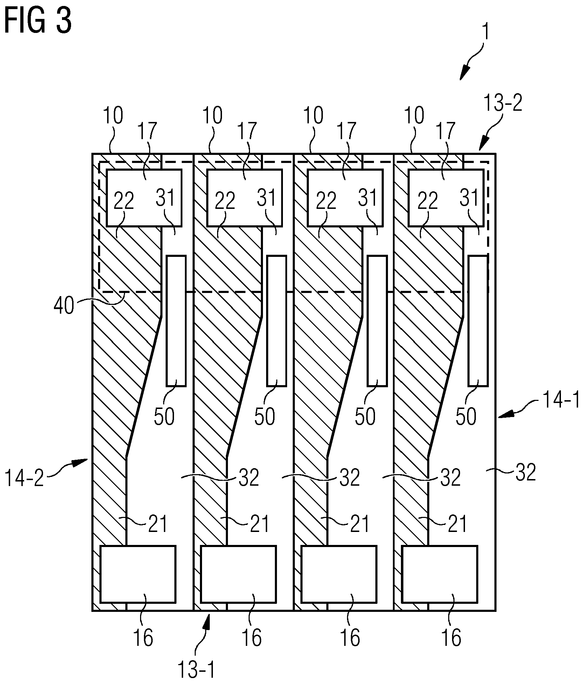

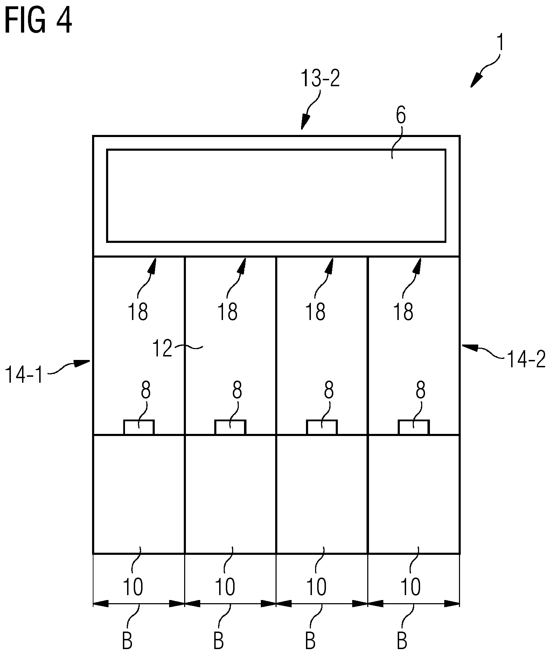

In den Figuren 1 und 2 ist ein erste erstes Ausführungsbeispiel eines erfindungsgemäßen Gehäusemoduls 10 für ein aus mehreren derartiger Gehäusemodule 10 aufgebautes, mehrpoliges Niederspannungs-Schutzschaltgerät 1 (siehe Figuren 3 und 4) in verschiedenen Ansichten schematisch dargestellt. Figur 1 zeigt dabei eine Schnittdarstellung des Gehäusemoduls 10 im Aufriss, Figur 2 eine hierzu korrespondierende Draufsicht, ebenfalls als Schnittdarstellung.

Das Gehäusemodul 10 ist aus Isolierstoff, beispielsweise einem Thermoplast oder einem Duroplast, gebildet und weist bei einer Breite B von nur einer Teilungseinheit (TE) eine Frontseite 11, eine der Frontseite 11 gegenüberliegend angeordnete Befestigungsseite 12, sowie die Front- und die Befestigungsseite 11, 12 verbindende erste und zweite Schmalseiten 13-1 und 13-2 sowie Breitseiten 14-1 und 14-2 auf. An der Frontseite 11 kann ein manuell betätigbares Betätigungselement (nicht dargestellt) angeordnet sein, mit dem das Niederspannungs-Schutzschaltgerät 1 manuell betätigbar ist, d.h. ein- oder ausgeschaltet werden kann.

In seinem Inneren weist das Gehäusemodul 10 einen ersten Funktionsbereich sowie einen zweiten Funktionsbereich auf, welche in der Breitenrichtung, d.h. in einer Orthogonalenrichtung der Breitseiten 14-1 und 14-2, nebeneinander angeordnet sind. Der erste Funktionsbereich und der zweite Funktionsbereich erstrecken sich jeweils von der ersten Schmalseite 13-1 zur zweiten Schmalseite 13-2 und sind zumindest abschnittsweise durch eine Trennwand 15 voneinander getrennt.

Der erste Funktionsbereich weist im Bereich der ersten Schmalseite 13-1 einen schmalen Teilbereich 21 sowie im Bereich der zweiten Schmalseite 13-2 einen breiten Teilbereich 22 auf. Der zweite Funktionsbereich weist im Bereich der ersten Schmalseite 13-1 einen breiten Teilbereich 32 sowie im Bereich der zweiten Schmalseite 13-2 einen schmalen Teilbereich 31 auf. Mit anderen Worten: der schmale Teilbereich 21 des ersten Funktionsbereichs ist neben dem breiten Teilbereich 32 des zweiten Funktionsbereichs, der breite Teilbereich 22 des ersten Funktionsbereichs neben dem schmalen Teilbereich 31 des zweiten Funktionsbereichs angeordnet. Die Trennwand 15 verläuft somit teilweise parallel, teilweise schräg zu den Breitseiten 14-1 und 14-2. Die schmalen Teilbereiche 21 und 31 müssen dabei nicht unmittelbar bis an die jeweilige Schmalseite 13-1 bzw. 13-2 heranreichen; Die Zeichnungsfiguren sind diesbezüglich lediglich schematisch zu verstehen.

Der erste Funktionsbereich dient dabei als Strompfadbereich für einen Phasen- oder Neutralleiter, welcher dazu vorgesehen und ausgebildet ist, einen mittels eines Schaltkontakts 3 unterbrechbaren Strompfad 2, ein magnetisches Auslösesystem 4 zum Öffnen des Schaltkontakts 3 bei Auftreten eines Kurzschlusses sowie ein thermisches Auslösesystem 5 zum Öffnen des Schaltkontakts 3 im Falle einer thermischen Überlast aufzunehmen. Aufgrund der geometrischen Baugröße dieser Komponenten ist das vergleichsweise voluminöse magnetische Auslösesystem 4 im breiten Teilbereich 22 des ersten Funktionsbereichs aufgenommen und gehaltert, während das deutlich kleinere thermische Auslösesystem 5 im schmalen Teilbereich 21 des ersten Funktionsbereichs angeordnet, d.h. aufgenommen und gehaltert ist. Im zweiten Funktionsbereich kann beispielsweise eine elektronische Funktionsbaugruppe 50 des Niederspannungs-Schutzschaltgerätes 1 angeordnet, d.h. aufgenommen und gehaltert sein.

Die elektronische Funktionsbaugruppe 50, der Strompfad 2, der Schaltkontakt 3 sowie das magnetische Auslösesystem 4 und das thermische Auslösesystem 5 sind in dem Gehäusemodul 10 wie in Figur 2 dargestellt montierbar. Es handelt es sich jedoch jeweils um eigenständige Baugruppen des Niederspannungs-Schutzschaltgerätes 1, welche nicht dem Gehäusemodul 10 zuzurechnen sind und in der Darstellung der Figur 2 daher nur schematisch als Bauvolumen-Platzhalter wiedergegeben sind.

Im Bereich der ersten Schmalseite 13-1 weist das Gehäusemodul 10 einen ersten Klemmen-Aufnahmeraum (16), im Bereich der zweiten Schmalseite 13-2 einen zweiten Klemmen-Aufnahmeraum (17) auf. Die beiden in den Figuren 1 und 2 dargestellten Klemmen-Aufnahmeräume (16, 17) stellen schematisch Bauvolumina dar, welche zur Aufnahme einer Anschlussklemme (nicht dargestellt) des Niederspannungs-Schutzschaltgerätes 1 vorgesehen sind. Insofern müssen die schmalen Teilbereiche 21 und 31 dabei nicht unmittelbar bis an die jeweilige Schmalseite 13-1 bzw. 13-2 heranreichen; Die Zeichnung ist diesbezüglich lediglich schematisch zu verstehen. Die Anschlussklemmen selbst können schraubenlos oder geschraubt ausgeführt sein, sind mit dem Strompfad 2 eingangsseitig bzw. ausgangsseitig elektrisch leitend verbunden und dienen somit als Eingangsklemme bzw. Ausgangsklemme zur Kontaktierung des Niederspannungs-Schutzschaltgerätes 1 mit einem elektrischen Leiter (nicht dargestellt) des zu überwachenden und zu schützenden Stromkreises.

Unterhalb des in Figur 2 links dargestellten ersten Klemmen-Aufnahmeraums (16) ist im Bereich der Befestigungsseite 12 ein Gehäusevolumen vorgesehen, in dem eine am Gehäusemodul 10 verschiebbar gelagerte, Rastvorrichtung 7 mit einer federbeaufschlagten Rastnase 8 montierbar ist. Mittels der Rastvorrichtung 7 kann das Gehäusemodul 10 an einer Trag- oder Hutschiene 9 durch Verrasten fixiert, d.h. befestigt werden, indem die federbeaufschlagte Rastnase 8 die Hutschiene 9 hintergreift und gegen ein gegenüberliegend angeordnetes, am Gehäusemodul 10 ausgebildetes Widerlager 18 drückt. Bei der Rastvorrichtung 7 handelt es sich wiederum um eine eigenständige Baugruppe, welche nicht dem Gehäusemodul 10, sondern dem Niederspannungs-Schutzschaltgerät 1 zuzurechnen ist.

Auf der anderen Seite, unterhalb des in Figur 2 rechts dargestellten zweiten Klemmen-Aufnahmeraums (17) weist das Gehäusemodul 10 im Bereich der Befestigungsseite 12 einen modularen Aufnahmeraum 41 auf, welcher sowohl von den Breitseiten 14-1 14-2 als auch von der Befestigungsseite 12 aus zugänglich ist. Dieser modularen Aufnahmeraum 41 bildet bei einer Kombination des Gehäusemoduls 10 mit einem weiteren Gehäusemodul 10 einen modulübergreifenden Aufnahmeraum 40 (siehe Figur 3), der zur Aufnahme einer modulübergreifenden Elektronikbaugruppe vorgesehen und ausgebildet ist. Bei der Elektronikbaugruppe kann es sich beispielsweise um eine gemeinsame Stromversorgung für eine oder mehrere in den einzelnen Gehäusemodulen 10 anordenbare elektronischen Funktionsbaugruppen 50 handeln (siehe Figur 3). Aufgrund der Anordnung des modulübergreifenden Aufnahmeraums 40 unterhalb des zweiten Klemmen-Aufnahmeraums 17 des jeweiligen Gehäusemoduls 10 ist auf einfache Art und Weise eine elektrische Kontaktierung der modulübergreifenden Elektronikbaugruppe mit einer oder mehreren der in den zweiten Klemmen-Aufnahmeräumen anordenbaren Anschlussklemmen möglich.

Figur 3 zeigt als Schnittdarstellung eine Draufsicht eines ersten Ausführungsbeispiels des erfindungsgemäßen Niederspannungs-Schutzschaltgerätes 1, welches aus mehreren Gehäusemodulen 10 (gemäß vorstehender Beschreibung zu den Figuren 1 und 2) gebildet ist. Bei dem dargestellten Niederspannungs-Schutzschaltgerät 1 handelt es sich um ein vierpoliges Gerät, welches entsprechend aus vier nebeneinander, d.h. Breitseite an Breitseite, angeordneten Einzelmodulen gebildet ist, wobei jedes der Einzelmodule ein Gehäusemodul 10 der vorstehend beschriebenen Art aufweist. In jedem der Gehäusemodule 10 ist ein Strompfad 2 (wie aus Figur 2 bekannt) angeordnet, welcher jedoch - ebenso wie der Schaltkontakt 2, die magnetische Auslöseeinrichtung 4 sowie die thermische Auslöseeinrichtung 5 - aus Gründen der Übersichtlichkeit weggelassen wurden. Drei der Strompfade 2 des vierpoligen Niederspannungs-Schutzschaltgerätes 1 sind dabei mit je einem der Phasenleiter eines dreiphasigen Systems, der vierte Strompfad 2 mit dem den drei Phasenleitern zugeordneten Neutralleiter kontaktierbar.

Unterhalb der zweiten Klemmen-Aufnahmeräume 17 ist der aus den einzelnen, modularen Aufnahmeräumen 41 der einzelnen Gehäusemodule 10 gebildete modulübergreifender Aufnahmeraum 40 als strichliertes Rechteck schematisch dargestellt. Der modulübergreifende Aufnahmeraum 40 ist dazu ausgebildet, eine modulübergreifende Elektronikbaugruppe (nicht dargestellt) aufzunehmen. Weiterhin ist - jeweils im schmalen Teilbereich 31 des zweiten Funktionsbereichs - in jedem der vier Gehäusemodule 10 eine elektronische Funktionsbaugruppe 50 angeordnet. Hierbei kann es sich beispielsweise um eine Kommunikationseinheit oder eine Messeinheit handeln. Auch weitere integrierte Funktionen wie die eines AFDD/Brandschutzschalters oder eines gleichstromsensitiven RCDs (Typ B) sind auf diese Weise realisierbar. Dies Anzahl von vier Funktionsbaugruppen 50 ist jedoch nicht zwingend erforderlich, sondern zeigt lediglich eine maximale Ausbaustufe des Niederspannungs-Schutzschaltgerätes 1. Selbstverständlich kann auch nur in einem der Gehäusemodule 10 eine elektronische Funktionsbaugruppe 50 angeordnet sein.

Bei der modulübergreifenden Elektronikbaugruppe kann es sich beispielsweise um eine modulübergreifende, d.h. gemeinsame Spannungsversorgung für die in den einzelnen Gehäusemodulen 10 anordenbaren elektronischen Funktionsbaugruppen 50 handeln. Der modulübergreifende Aufnahmeraum 40 bietet aufgrund seiner Lage im Gehäuse unterhalb der zweiten Klemmen-Aufnahmeräume 17 eine einfache Möglichkeit zur Kontaktierung mit einer oder mehreren in den zweiten Klemmen-Aufnahmeräumen 17 angeordneten Anschlussklemmen. Da auch die elektronischen Funktionsbaugruppen 50 in unmittelbarer Nähe zu dem modulübergreifenden Aufnahmeraum 40 angeordnet sind, können auch diese auf einfache Art und Weise mit der modulübergreifenden Elektronikbaugruppe elektrisch leitend verbunden und damit mit elektrischer Spannung vorsorgt werden.

Bei der Darstellung der Figur 3 handelt es sich zwar um ein vierpoliges Niederspannungs-Schutzschaltgerät; es ist jedoch ebenso möglich, aus drei Einzelmodulen, welche jeweils ein Gehäusemodul 10 der vorstehend beschriebenen Art aufweisen, ein zwei- oder dreipoliges Niederspannungs-Schutzschaltgerät zu bilden.

In Figur 4 ist eine Unteransicht des erfindungsgemäßen Niederspannungs-Schutzschaltgerätes 1 (Blick auf die Befestigungsseite 12) schematisch dargestellt. Jedes der Gehäusemodule 10 weist eine Breite B von einer Teilungseinheit auf, so dass das gesamte, aus vier Gehäusemodulen 10 gebildete, vierpolige Niederspannungs-Schutzschaltgerät 1 eine gesamte Breite von vier Teilungseinheiten aufweist. In der unteren Bildhälfte sind die Rastnasen 8 zur Befestigung des Niederspannungs-Schutzschaltgerätes 1 an eine Trag- oder Hutschiene zu erkennen. Im oberen Bildbereich, nahe der Breitseite 14-2, weist das vierpolige Niederspannungs-Schutzschaltgerät 1 eine Abdeckung 6 auf, welche fest aber lösbar mit dem aus den einzelnen Gehäusemodulen 10 gebildeten Gehäuse des Niederspannungs-Schutzschaltgerätes 1 verbunden ist. Mit Hilfe der Abdeckung 6 ist der modulübergreifende Aufnahmeraum 40 verschließbar und somit gegen äußere Umwelteinflüsse wie Staub oder Feuchtigkeit sowie gegen unbefugte Berührung geschützt. Weiterhin ist - nach Entfernen des Deckels - der modulübergreifende Aufnahmeraum 40 gut zugänglich, beispielsweise um die modulübergreifende Elektronikbaugruppe zu montieren oder mit einer oder mehrere der Anschlussklemmen sowie mit einer oder mehreren der elektronischen Funktionsbaugruppen 50 elektrisch leitend zu verbinden.

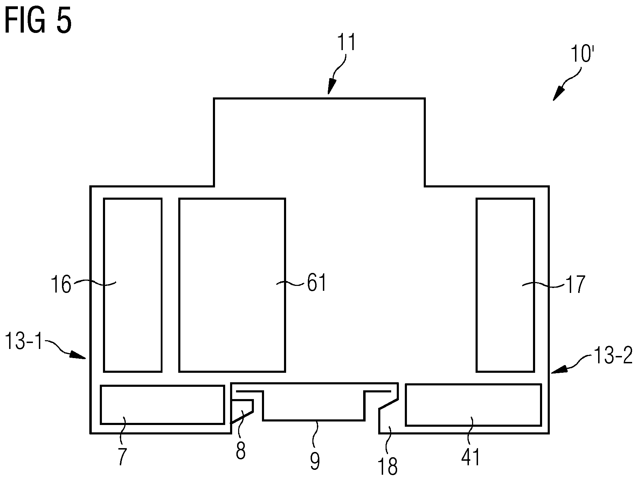

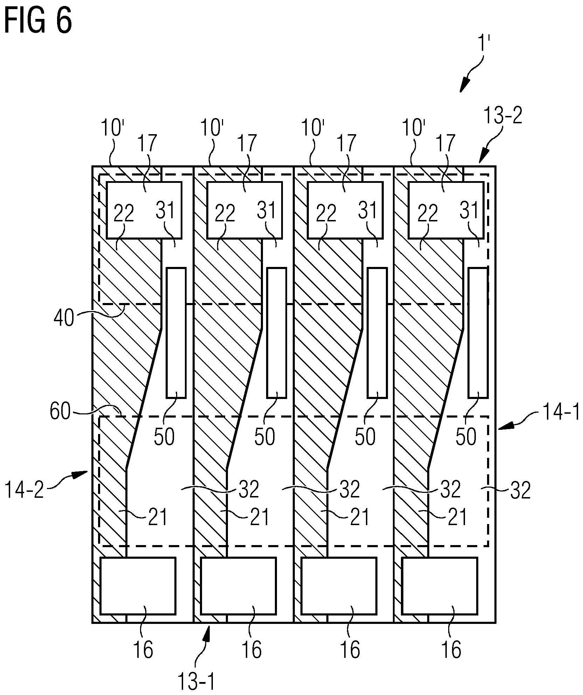

In Figur 5 ist ein zweites Ausführungsbeispiel eines erfindungsgemäßen Gehäusemoduls 10' für ein aus mehreren derartiger Gehäusemodule 10' aufgebautes, mehrpoliges Niederspannungs-Schutzschaltgerät 1' (siehe Figur 6) in verschiedenen Ansichten schematisch dargestellt. Der strukturelle Aufbau dieses Gehäusemoduls 10' entspricht dabei im Wesentlichen dem strukturellen Aufbau des in den Figuren 1 und 2 beschriebenen Gehäusemodul 10, mit dem Unterschied, dass dieses Gehäusemodul 10' eine Einschuböffnung 61 aufweist, welche sich von der ersten Breitseite 14-1 zur gegenüberliegenden Breitseite 14-2 erstreckt, wodurch ein modularer Einbauraum gebildet ist, welcher bei einer Kombination mit einem weiteren Gehäusemodul 10' einen modulübergreifenden Einbauraum 60 (siehe Figur 6) bildet.

Korrespondierend zu dem in Figur 5 dargestellten Gehäusemodul 10' ist in Figur 6 ein zweites Ausführungsbeispiel des erfindungsgemäßen Niederspannungs-Schutzschaltgerätes 1' dargestellt, welches aus vier Gehäusemodulen 10' gebildet ist. Dabei wird deutlich, dass sich der modulübergreifende Einbauraum 60 von der ersten Breitseite 14-1 zur gegenüberliegenden Breitseite 14-2 über alle Gehäusemodule 10' hin erstreckt, und zwar jeweils im Bereich des schmalen Teilbereichs 21 des ersten Funktionsbereichs sowie des daneben angeordneten breiten Teilbereichs 32 des zweiten Funktionsbereichs eines jeden Gehäusemoduls 10'. Der modulübergreifende Einbauraum 60 ist dabei zur Aufnahme eines Summenstromwandlers vorgesehen, um auf diese Art ein vierpoliges Niederspannungs-Schutzschaltgerät vom Typ FI/LS oder RCBO zu bilden.

In Figur 6 ist zwar ein vierpoliges Niederspannungs-Schutzschaltgerät 1' dargestellt; es ist jedoch ebenso möglich, aus drei Einzelmodulen, welche jeweils ein Gehäusemodul 10' der vorstehend beschriebenen Art aufweisen, ein zwei- oder dreipoliges Niederspannungs-Schutzschaltgerät vom Typ FI/LS oder RCBO zu bilden.

Mit Hilfe des erfindungsgemäßen Gehäusemoduls 10 bzw. 10' sowie der daraus gebildeten erfindungsgemäßen Niederspannungs-Schutzschaltgeräte 1 bzw. 1' ist es möglich, in einem eng gepackten Reiheneinbaugerät einen Bauraum - den modularer Aufnahmeraum 41, welcher bis dato ungenutzt oder kaum genutzt war - zur Aufnahme und Anordnung einer weiteren Gerätekomponente zu verwenden, indem bei Kombination mehrerer Gehäusemodule 10 bzw. 10' die einzelnen modularen Aufnahmeräume 41 zu einem modulübergreifenden Aufnahmeraum 40 kombiniert werden, in dem dann eine modulübergreifende Baugruppe, beispielsweise eine modulübergreifende Spannungsversorgung, angeordnet werden kann, welche über einen einfachen Zugang zu allen Gehäusemodulen 10 bzw. 10' sowie zu allen darin angeordneten Komponenten - insbesondere den unmittelbar darüber angeordneten Anschlussklemmen sowie den elektronischen Funktionsbaugruppen 50 - verfügt. Auf diese Weise wird nur eine modulübergreifende Spannungsversorgung benötigt, um die in den einzelnen Gehäusemodulen 10 bzw. 10' angeordneten elektronischen Funktionsbaugruppen 50 mit der benötigten Arbeitsspannung zu versorgen. Die jeweiligen elektronischen Funktionsbaugruppen 50 können dabei je nach Bedarf (unterschiedliche Spannungswerte, Gleich- oder Wechselstrom) versorgt werden.

### Bezugszeichenliste

- 1: Niederspannungs-Schutzschaltgerät
- 2: Strompfad
- 3: Schaltkontakt
- 4: magnetisches Auslösesystem
- 5: thermisches Auslösesystem
- 6: Abdeckung
- 7: Rastvorrichtung
- 8: Rastnase
- 9: Hutschiene
- 10: Gehäusemodul
- 11: Frontseite
- 12: Befestigungsseite
- 13-1: Schmalseite
- 13-2: Schmalseite
- 14-1: Breitseite
- 14-2: Breitseite
- 15: Trennwand
- 16: erster Klemmen-Aufnahmeraum
- 17: zweiter Klemmen-Aufnahmeraum
- 18: Widerlager

- 21: schmaler Teilbereich
- 22: breiter Teilbereich
- 31: schmaler Teilbereich
- 32: breiter Teilbereich

- 40: modulübergreifender Aufnahmeraum
- 41: modularer Aufnahmeraum

- 50: elektronische Funktionsbaugruppe

- 60: modulübergreifender Einbauraum
- 61: Einschuböffnung

- B: Breite

## Patentansprüche

1. Einpoliges Gehäusemodul (10, 10') aus Isolierstoff für ein aus mehreren Gehäusemodulen (10, 10') aufgebautes, mehrpoliges Niederspannungs-Schutzschaltgerät (1, 1'), aufweisend eine Frontseite (11), eine der Frontseite (11) gegenüberliegend angeordnete Befestigungsseite (12), sowie die Front- und die Befestigungsseite (11, 12) verbindende, erste und zweite Schmal- und Breitseiten (13-1, 13-2, 14-1, 14-2),
**dadurch gekennzeichnet,**
- **dass** das Gehäusemodul (10, 10') einen von der Befestigungsseite (12) aus zugänglichen modularen Aufnahmeraum (41) aufweist, welcher bei einer Kombination des Gehäusemoduls (10) mit einem weiteren Gehäusemodul (10) einen modulübergreifenden Aufnahmeraum (40) bildet, der zur Aufnahme einer modulübergreifenden Elektronikbaugruppe vorgesehen und ausgebildet ist.

2. Gehäusemodul (10, 10') nach Anspruch 1,
**dadurch gekennzeichnet,**
**dass** der modulare Aufnahmeraum (41) verschließbar ist.

3. Gehäusemodul (10, 10') nach einem der vorherigen Ansprüche, **gekennzeichnet durch**
- einen ersten Klemmen-Aufnahmeraum (16) zur Aufnahme einer ersten Anschlussklemme, welcher im Bereich der ersten Schmalseite (13-1) in dem Gehäusemodul (10, 10') ausgebildet ist,
- einen zweiten Klemmen-Aufnahmeraum (17) zur Aufnahme einer zweiten Anschlussklemme, welcher im Bereich der zweiten Schmalseite (13-2) in dem Gehäusemodul (10, 10') ausgebildet ist,
- wobei der modulare Aufnahmeraum (41) unterhalb des zweiten Klemmen-Aufnahmeraums (17) angeordnet ist.

4. Gehäusemodul (10, 10') nach einem der vorherigen Ansprüche, **dadurch gekennzeichnet,**
- **dass** das Gehäusemodul (10, 10') einen ersten Funktionsbereich (21, 22) und einem zweiten Funktionsbereich (31, 32) aufweist, welche nebeneinander angeordnet sind,
- wobei der erste Funktionsbereich (21, 22) als Strompfadbereich dient, welcher dazu vorgesehen und ausgebildet ist, einen mittels eines Schaltkontakts (3) unterbrechbaren Strompfad (2) sowie ein magnetisches und ein thermisches Auslösesystem (4, 5) zum Öffnen des Schaltkontakts (3) aufzunehmen, und
- wobei der zweite Funktionsbereich (31, 32) dazu vorgesehen und ausgebildet ist, eine elektronische Funktionsbaugruppe (50) aufzunehmen.

5. Gehäusemodul (10, 10') nach Anspruch 4,
**dadurch gekennzeichnet,**
**dass** der erste Funktionsbereich und der zweite Funktionsbereich jeweils einen schmalen Teilbereich (21, 31) sowie einen breiten Teilbereich (22, 32) aufweisen, wobei der schmale Teilbereich (21) des ersten Funktionsbereichs neben dem breiten Teilbereich (32) des zweiten Funktionsbereichs, und der breite Teilbereich (22) des ersten Funktionsbereichs neben dem schmalen Teilbereich (31) des zweiten Funktionsbereichs angeordnet sind.

6. Gehäusemodul (10, 10') nach Anspruch 5,
**dadurch gekennzeichnet,**
**dass** die elektronische Funktionsbaugruppe (50) im schmalen Teilbereich (31) des zweiten Funktionsbereichs anordenbar ist.

7. Gehäusemodul (10, 10') nach einem der vorherigen Ansprüche, **dadurch gekennzeichnet,**
**dass** das Gehäusemodul (10, 10') eine Einschuböffnung (61) aufweist, welche sich von der einen zur anderen Breitseite (14-1, 14-2) erstreckt, wodurch ein Einbauraum gebildet ist, welcher bei einer Kombination mit einem weiteren Gehäusemodul (10) als modulübergreifender Einbauraum (60) zur Aufnahme eines Summenstromwandlers vorgesehen ist.

8. Gehäusemodul (10, 10') nach Anspruch 7 rückbezogen auf einen der Ansprüche 5 oder 6,
**dadurch gekennzeichnet,**
**dass** die Einschuböffnung (61) im Bereich des schmalen Teilbereichs (21) sowie des daneben angeordneten breiten Teilbereichs (32) von der einen zur anderen Breitseite (14-1, 14-2) ausgebildet ist.

9. Mehrpoliges Niederspannungs-Schutzschaltgerät (1, 1'), welches zumindest zwei nebeneinander angeordnete, nach einem Anspruch 1 bis 8 gebildete Gehäusemodule (10, 10') aufweist,
**dadurch gekennzeichnet,**
- **dass** in einem ersten Funktionsbereich (21, 22) zumindest eines der Gehäusemodule (10, 10') ein Strompfad (2), ein Schaltkontakt (3) sowie ein magnetisches und ein thermisches Auslösesystem (4, 5) zum Öffnen des Schaltkontakts (3) aufgenommen und gehaltert sind, um den Strompfad (2) bei Auftreten eines vordefinierten Ereignisses zu unterbrechen,
- **dass** in einem zweiten Funktionsbereich (31, 32) zumindest eines der Gehäusemodule (10, 10') eine elektronische Funktionsbaugruppe (50) aufgenommen und gehaltert ist,
- **dass** durch die nebeneinander angeordneten Aufnahmeräume (41) der zumindest zwei Gehäusemodule (10, 10') ein modulübergreifender Aufnahmeraum (40) gebildet ist, in dem eine modulübergreifenden Elektronikbaugruppe aufgenommen und gehaltert ist, welche mit der zumindest einen elektronischen Funktionsbaugruppe (50) elektrisch leitend verbunden ist.

10. Niederspannungs-Schutzschaltgerät (1, 1') nach Anspruch 9, **dadurch gekennzeichnet,**
- **dass** im ersten Klemmen-Aufnahmeraum (16) jedes der Gehäusemodule (10, 10') jeweils eine erste Anschlussklemme und im zweiten Klemmen-Aufnahmeraum (17) jedes der Gehäusemodule (10, 10') jeweils eine zweite Anschlussklemme aufgenommen und gehaltert sind,
- **dass** die modulübergreifende Elektronikbaugruppe mit zumindest einer der Anschlussklemmen elektrisch leitend verbunden ist.

## Claims

1. Single-pole housing module (10, 10'), made of an insulating material, for a multi-pole low-voltage protective switching device (1, 1') formed from a plurality of housing modules (10, 10'), having a front side (11), a fastening side (12) arranged opposite the front side (11), and first and second narrow and wide sides (13-1, 13-2, 14-1, 14-2) connecting the front side (11) and the fastening side (12),
**characterized in that**
- the housing module (10, 10') has a modular receiving space (41), which can be accessed from the fastening side (12) and which, when the housing module (10) is combined with another housing module (10), forms a receiving space (40) spanning the module and provided and designed to receive an electronic assembly spanning the module.

2. Housing module (10, 10') according to Claim 1,
**characterized in that**
the modular receiving space (41) is closable.

3. Housing module (10, 10') according to either of the preceding claims,
- a first terminal receiving space (16) for receiving a first connection terminal, which is formed in the region of the first narrow side (13-1) in the housing module (10, 10'),
- a second terminal receiving space (17) for receiving a second connection terminal, which is formed in the region of the second narrow side (13-2) in the housing module (10, 10'),
- wherein the modular receiving space (41) is arranged below the second terminal receiving space (17).

4. Housing module (10, 10') according to one of the preceding claims, **characterized in that**
- the housing module (10, 10') has a first functional region (21, 22) and a second functional region (31, 32) which are arranged next to one another,
- wherein the first functional region (21, 22) is used as a current path region which is provided and designed to receive a current path (2), which can be interrupted by means of a switching contact (3), and a magnetic and a thermal trip system (4, 5) in order to open the switching contact (3), and
- wherein the second functional region (31, 32) is provided and designed to receive an electronic functional assembly (50).

5. Housing module (10, 10') according to Claim 4, **characterized in that**
the first functional region and the second functional region each have a narrow subregion (21, 31) and a wide subregion (22, 32), wherein the narrow subregion (21) of the first functional region is arranged next to the wide subregion (32) of the second functional region and the wide subregion (22) of the first function region is arranged next to the narrow subregion (31) of the second functional region.

6. Housing module (10, 10') according to Claim 5, **characterized in that**
the electronic functional assembly (50) can be arranged in the narrow subregion (31) of the second functional region.

7. Housing module (10, 10') according to one of the preceding claims, **characterized in that**
the housing module (10, 10') has an insertion opening (61), which extends from one wide side (14-1, 14-2) to the other, thus forming an installation space, which, when combined with a further housing module (10), is provided as an installation space (60) that spans the modules for receiving a summation current transducer.

8. Housing module (10, 10') according to Claim 7, with reference back to one of Claims 5 or 6,
**characterized in that**
the insertion opening (61) is formed in the region of the narrow subregion (21) and the wide subregion (32) arranged next to it from one wide side (14-1, 14-2) to the other.

9. Multi-pole low-voltage protective switching device (1, 1'), which comprises at least two housing modules (10, 10') formed according to one of Claims 1 to 8 and arranged next to one another,
**characterized in that**
- a current path (2), a switching contact (3) and a magnetic and a thermal trip system (4, 5) for opening the switching contact (3) are received and held in a first functional region (21, 22) of at least one of the housing modules (10, 10') in order to interrupt the current path (2) when a predefined event occurs,
- an electronic functional assembly (50) is received and held in a second functional region (31, 32) of at least one of the housing modules (10, 10'),
- a receiving space (40) that spans the modules and in which an electronic assembly that spans the modules is received and held is formed by the receiving spaces (41), arranged next to one another, of the at least two housing modules (10, 10'), said electronics assembly being electrically conductively connected to the at least one electronic functional assembly (50).

10. Low-voltage protective switching device (1, 1') according to Claim 9, **characterized in that**
- a respective first connection terminal is received and held in the first terminal receiving space (16) of each of the housing modules (10, 10') and a respective second connection terminal is received and held in the second terminal receiving space (17) of each of the housing modules (10, 10'),
- the electronics assembly that spans the modules is electrically conductively connected to at least one of the connection terminals.

## Revendications

1. Module de boîtier unipolaire (10, 10') en matériau isolant, destiné à un appareil de protection basse tension multipolaire (1, 1') constitué de plusieurs modules de boîtier (10, 10'), présentant un côté avant (11), un côté de fixation (12) agencé à l'opposé du côté avant (11), et des premier et second côtés étroits et larges (13-1, 13-2, 14-1, 14-2) reliant les côtés avant et de fixation (11, 12), **caractérisé en ce que**
- le module de boîtier (10, 10') présente un espace d'accueil modulaire (41) accessible depuis le côté de fixation (12) et formant un espace d'accueil (40) à mise en prise de modules prévu et conçu afin d'accueillir un ensemble électronique à mise en prise de modules lorsque le module de boîtier (10) est combiné avec un module de boîtier (10) supplémentaire.

2. Module de boîtier (10, 10') selon la revendication 1, **caractérisé en ce que** l'espace d'accueil modulaire (41) peut être fermé.

3. Module de boîtier (10, 10') selon l'une quelconque des revendications précédentes, **caractérisé par**
- un premier espace d'accueil de borne (16) permettant d'accueillir une première borne de raccordement réalisé au sein du module de boîtier (10, 10') dans la région du premier côté étroit (13-1),
- un second espace d'accueil de borne (17) permettant d'accueillir une seconde borne de raccordement réalisé au sein du module de boîtier (10, 10') dans la région du second côté étroit (13-2),
- dans lequel l'espace d'accueil modulaire (41) est agencé sous le second espace d'accueil de borne (17).

4. Module de boîtier (10, 10') selon l'une quelconque des revendications précédentes, **caractérisé en ce que**
- le module de boîtier (10, 10') présente une première région fonctionnelle (21, 22) et une seconde région fonctionnelle (31, 32) agencées côte à côte,
- dans lequel la première région fonctionnelle (21, 22) sert de région de trajet de courant prévue et conçue afin d'accueillir un trajet de courant (2) pouvant être interrompu au moyen d'un contact de commutation (3) et un système de déclenchement magnétique et thermique (4, 5) permettant d'ouvrir le contact de commutation (3), et
- dans lequel la seconde région fonctionnelle (31, 32) est prévue et conçue afin d'accueillir un ensemble fonctionnel électronique (50).

5. Module de boîtier (10, 10') selon la revendication 4, **caractérisé en ce que** la première région fonctionnelle et la seconde région fonctionnelle présentent respectivement une sous-région étroite (21, 31) et une sous-région large (22, 32), dans lequel la sous-région étroite (21) de la première région fonctionnelle est agencée à côté de la sous-région large (32) de la seconde région fonctionnelle, et la sous-région large (22) de la première région fonctionnelle est agencée à côté de la sous-région étroite (31) de la seconde région fonctionnelle.

6. Module de boîtier (10, 10') selon la revendication 5, **caractérisé en ce que** l'ensemble fonctionnel électronique (50) peut être agencé dans la sous-région étroite (31) de la seconde région fonctionnelle.

7. Module de boîtier (10, 10') selon l'une quelconque des revendications précédentes, **caractérisé en ce que** le module de boîtier (10, 10') présente une ouverture d'insertion (61) qui s'étend d'un côté large à l'autre côté large (14-1, 14-2), ce qui forme un espace de montage qui, lorsqu'il est combiné avec un module de boîtier (10) supplémentaire, est prévu afin de faire office d'espace de montage (60) à mise en prise de modules permettant d'accueillir un transformateur de courant totalisateur.

8. Module de boîtier (10, 10') selon la revendication 7, liée à la revendication 5 ou 6, **caractérisé en ce que** l'ouverture d'insertion (61) est réalisée d'un côté large à l'autre côté large (14-1, 14-2) dans la région de la sous-région étroite (21) et de la sous-région large (32) agencée à côté.

9. Appareil de protection basse tension multipolaire (1, 1'), présentant au moins deux modules de boîtier (10, 10') agencés côte à côte et réalisés selon l'une quelconque des revendications 1 à 8, **caractérisé en ce que**
- dans une première région fonctionnelle (21, 22) d'au moins un des modules de boîtier (10, 10'), un trajet de courant (2), un contact de commutation (3) et un système de déclenchement magnétique et thermique (4, 5) permettant d'ouvrir le contact de commutation (3) sont accueillis et retenus afin d'interrompre le trajet de courant (2) en cas de survenue d'un événement prédéfini,
- **en ce qu'**un ensemble fonctionnel électronique (50) est accueilli et retenu dans une seconde région fonctionnelle (31, 32) d'au moins un des modules de boîtier (10, 10'),
- **en ce qu'**un espace d'accueil (40) à mise en prise de modules, au sein duquel est accueilli et retenu un ensemble électronique à mise en prise de modules relié de manière électriquement conductrice au au moins un ensemble fonctionnel électronique (50), est formé grâce aux espaces d'accueil (41) agencés côte à côte des au moins deux modules de boîtier (10, 10').

10. Appareil de protection basse tension (1, 1') selon la revendication 9, **caractérisé en ce que**
- respectivement une première borne de raccordement est accueillie et retenue dans le premier espace d'accueil de borne (16) de chacun des modules de boîtier (10, 10') et respectivement une seconde borne de raccordement est accueillie et retenue dans le second espace d'accueil de bornes (17) de chacun des modules de boîtier (10, 10'),
- l'ensemble électronique à mise en prise de modules est relié de manière électriquement conductrice à au moins une des bornes de raccordement.
